# EUROPEAN PATENT SPECIFICATION

(11) **EP 2 519 656 B1**
(45) Date of publication and mention of the grant of the patent: **04.10.2017**
(21) Application number: 10841200.8
(22) Date of filing: 24.12.2010
(51) Int. Cl.: C23C 14/24, C23C 14/54, B01D 1/00, C23C 16/448, C23C 16/52

(54) **VAPORIZATION APPARATUS**
VERDAMPFUNGSVORRICHTUNG
APPAREIL DE VAPORISATION

(30) Priority: 31.12.2009 KR 20090135890
(43) Date of publication of application: 07.11.2012
(73) Proprietor: SNU Precision Co., Ltd., Seoul 151-050 (KR)
(72) Inventor: SEO, Seung Cheol, Pyeongtaek-si Gyeonggi-do 450-747 (KR); GONG, Doo Won, Seoul 158-848 (KR); LEE, Jong Ha, Anyang-si Gyeonggi-do 430-703 (KR); LEE, Kyung Bum, Pyeongtaek-si Gyeonggi-do 450-150 (KR); JUNG, Sung Jae, Seongnam-si Gyeonggi-do 463-928 (KR); CHO, Whang Sin, Seoul 122-819 (KR)
(74) Representative: Groth & Co. KB
(86) International application number: PCT/KR2010/009316
(87) International publication number: WO 2011/081368

(56) References cited:
- JP-A- H02 138 462
- JP-A- 2003 222 472
- JP-A- 2006 111 926
- JP-A- 2006 111 965
- JP-A- 2008 088 531
- JP-A- 2009 084 665
- JP-A- 2009 084 679
- KR-B1- 100 926 437
- US-A1- 2005 229 856
- US-A1- 2007 298 159

## Description

### Technical Field

The present disclosure relates to a vaporization apparatus and a method for controlling the same, and more particularly, to a vaporization apparatus capable of supplying a raw material in a vaporized state, that is, in a gas state, and a control method for the same.

### Background Art

In general, a vacuum heating vapor deposition method accompanies the process of vaporizing a raw material when the raw material is solid or liquid. For this, a raw material vaporization apparatus is equipped at the inside or the outside of a chamber. The raw material vaporization apparatus generally includes a vaporization unit for vaporizing a solid or liquid raw material, and a vaporization quantity control unit for measuring quantity of a raw material to be vaporized and adjusting a vaporization quantity to a desired value based on the measured value.

The vaporization quantity control unit measures variation of an oscillation frequency of crystal by a crystal sensor or measures variation of a pressure by a pressure gauge. When the vaporization quantity is higher than the desired value as a result of the measurement, a supplied raw material quantity is reduced or a heating temperature or an applied power is lowered. In the opposite case, the vaporization quantity control unit may increase the supplied raw material quantity or increase the heating temperature or the applied power.

However, in case of using the crystal sensor, a lifespan of the crystal sensor expires when a predetermined quantity or more is deposited on a surface of the crystal sensor and therefore the measurement cannot be precisely performed any more. Therefore, the crystal sensor is inappropriate in a case where a large quantity of raw material needs to be supplied or a process needs to be continuously performed for a long time. In addition, in a case where the raw material is not apt to favorably adsorb to the crystal sensor surface, the crystal sensor is not applicable since the variation of the oscillation frequency is not proportional to the vaporization quantity.

In case of using the pressure gauge, the vaporized raw material may chemically react with an internal part of the pressure gauge and even cause malfunction of the apparatus. Also, the vaporized raw material may clog an inlet path of the pressure gauge after use for some time, thereby disabling the pressure gauge from precisely measuring the pressure. Furthermore, the pressure gauge is capable of measuring variation of a vaporization pressure approximately rather than precisely since it is not sensitive to the pressure variation. That is, the pressure gauge is inappropriate for a process requiring precise control.

Thus, the above vaporization quantity control method according to the related art is inadequate for latest processes requiring various raw material supply for formation of a heterogeneous membrane, large quantity raw material supply according to use of a large area substrate, long time raw material supply for securing productivity, and precise raw material supply according to the scale down of the process.

A method for forming phosphor layer is disclosed in the JP 2008 088531 A. An organic evaporator is disclosed in US 2007/298159 A1 and a device for producing thin film is disclosed in JP H02 138462 A. In US 2005/0229856 A1 a liquid metal evaporation source for use in Molecular Beam Epitaxy and related metal vacuum deposition techniques is disclosed, wherein an evaporator is maintained at a high temperature to evaporate a liquid metal, a reservoir for holding the liquid metal source is maintained at a temperature above the melting point of the metal but below the temperature in the evaporator, and a hollow transport tube connecting the evaporator and reservoir is maintained at a temperature between these temperatures. The reservoir is in the shape of a hollow cylinder with a close-fitting cylindrical piston which is used to force the liquid metal through the hollow transport tube into the evaporator.

### Disclosure of Invention

It is the object of the invention to overcome the above mentioned problems. This object is achieved by a vaporization apparatus having the features according to the independent claim. The present disclosure provides a vaporization apparatus equipped with a vaporization quantity control unit appropriate for various raw material supply, large quantity raw material supply, long time raw material supply, and precise raw material supply, and a control method for the same.

The present disclosure also provides a vaporization apparatus equipped with a vaporization quantity control unit capable of real-time check of a vaporization quantity of raw material, and a control method for the same.

The present disclosure also provides a vaporization apparatus improved in vaporization speed and quality by improving the structure of a vaporizer, and a control method for the same.

In accordance with an exemplary embodiment, a vaporization apparatus includes a vaporization crucible adapted to receive a raw material; a vaporization heating unit adapted to vaporize the raw material by heating the vaporization crucible; a temperature measuring unit adapted to measure temperature of the vaporization crucible; a power measuring unit adapted to measure an applied power of the vaporization heating unit; and a control unit adapted to control a vaporization quantity of the raw material based on any one of a temperature variation value of the temperature measuring unit and a power variation value of the power measuring unit.

The control unit may control the temperature of the vaporization crucible to be constant and control the vaporization quantity of the raw material based on the power variation value of the power measuring unit.

The control unit may control the applied power of the vaporization heating unit to be constant and control the vaporization quantity of the raw material based on the temperature variation value of the temperature measuring unit.

The temperature measuring unit may be installed in the vaporization crucible.

The vaporization apparatus further includes a housing disposed to surround the vaporization crucible; and a pressure gauge adapted to measure a vaporization pressure in the housing. Alternatively, the vaporization apparatus may further include a pressure gauge adapted to measure a vaporization pressure in the vaporization crucible.

The vaporization apparatus may further include a raw material supply unit adapted to supply the raw material to the vaporization crucible, and the raw material supply unit may include a liquefaction crucible adapted to store a raw material in a solid state; a liquefaction heating unit adapted to liquefy the raw material by heating the liquefaction crucible; and a discharge unit adapted to discharge the raw material in the liquefaction crucible to the outside.

The vaporization crucible may include a body part including an inner space to receive the raw material; and at least one discharge plate connected to the body part to discharge the raw material received in the inner space.

The discharge plate may be provided in a plural number and partition the inner space of the body part into upper and lower spaces. The discharge plate may include the vaporization heating unit embedded therein.

The discharge plate may be configured such that a center and a periphery of an outer surface thereof have different heights. For example, the outer surface of the discharge plate may have a lampshade shape or a funnel shape.

In accordance with another exemplary embodiment, a vaporization apparatus includes a vaporization crucible adapted to receive a raw material; and a vaporization heating unit adapted to heat the vaporization crucible, wherein the vaporization crucible includes a body part comprising an inner space to receive the raw material; and a plurality of discharge plates adapted to comprise at least one outlet to discharge the raw material received in the inner space and partition the inner space into upper and lower spaces.

The vaporization heating unit may be disposed at an outside of the vaporization crucible or embedded in at least one of the plurality of discharge plates.

In accordance with still another exemplary embodiment, a vaporization apparatus includes a vaporization crucible adapted to receive a raw material; and a vaporization heating unit adapted to heat the vaporization crucible, wherein the vaporization crucible is configured such that a center and a periphery of a bottom surface thereof which receives the raw material have different heights. The center may be higher than the periphery in the bottom surface of the vaporization crucible. On the other hand, the center may be lower than the periphery in the bottom surface of the vaporization crucible.

In accordance with yet another exemplary embodiment, a control method for a vaporization apparatus includes supplying a raw material to a vaporization crucible; heating the vaporization crucible by a vaporization heating unit to vaporize the raw material; calculating a vaporization quantity of the raw material by measuring any one of a temperature variation value of the vaporization crucible and a power variation value of the vaporization heating unit; and controlling a supply quantity of the raw material supplied to the vaporization crucible based on the vaporization quantity.

The temperature variation value of the vaporization crucible may be measured while power of the vaporization heating unit is constantly maintained.

The power variation value of the vaporization heating unit may be measured while temperature of the vaporization crucible is constantly maintained.

The power variation value may include a variation value of any one of electric power, voltage, and current.

The calculating of the vaporization quantity may include measuring a pressure variation value of an inside of the housing surrounding the vaporization crucible, and the vaporization quantity may be calculated based on any one of the temperature variation value and the power variation value, and the pressure variation value.

### Advantageous Effects of Invention

According to the embodiments, a non-contact/electronic method is used, which measures a vaporization quantity through a temperature variation value and a power variation value during vaporization of a raw material. Therefore, since, differently from a contact method, a vaporization quantity measuring unit does not directly contact a raw material gas, various raw materials can be supplied and, furthermore, large quantity raw material supply or long time raw material supply can be achieved without deterioration of the function. In addition, preciseness of the raw material supply may be enhanced since the electronic method is capable of precise measurement of the vaporization quantity.

According to the embodiments, not only the vaporization quantity may be checked in real time but also various information on the vaporization process, including vaporization speed, vaporization temperature, and vaporization power, may be obtained. Therefore, it is easy to design the optimum conditions for the vaporization according to characteristics of the raw material.

In addition, conditions for fast and stable vaporization may be guaranteed by selecting the optimum structure of a vaporization unit according to characteristics of the raw material from various structures suggested through the embodiments.

Also, the embodiments apply a gradual vaporization method which liquefies a large quantity of the raw material and then vaporizes only a small required quantity of the raw material. Since the large quantity raw material is applied, the productivity is increased. In addition, since the small quantity is vaporized, it is convenient to control the vaporization speed and maintain the vaporization quality.

### Brief Description of Drawings

Exemplary embodiments can be understood in more detail from the following description taken in conjunction with the accompanying drawings, in which:
FIG. 1 is a view showing a vaporization apparatus according to one embodiment;
FIG. 2 is a graph showing a power variation value during a vaporization process being performed at a constant temperature according to a first experiment example;
FIG. 3 is a graph showing a temperature variation value during the vaporization process being performed with a constant power according to a second experiment example;
FIG. 4 is a sectional view of a vaporizer according to a first modified version of the embodiment;
FIG. 5 is a perspective view of the vaporizer according to the first modified version of the embodiment;
FIG. 6 is a sectional view of a vaporizer according to a second modified version of the embodiment;
FIG. 7 is a perspective view of the vaporizer according to the second modified version of the embodiment;
FIG. 8 is a sectional view showing a vaporizer according to a third modified version of the embodiment;
FIG. 9 is a sectional view showing operational processes of the vaporizer according to the third modified version;
FIG. 10 is a sectional view showing a vaporizer according to a fourth modified version of the embodiment;
FIG. 11 is a sectional view showing operational processes of the vaporizer according to the fourth modified version; and
FIG. 12 is a view showing a vaporization apparatus according to a second embodiment.

### Mode for the Invention

Hereinafter, specific embodiments will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art.

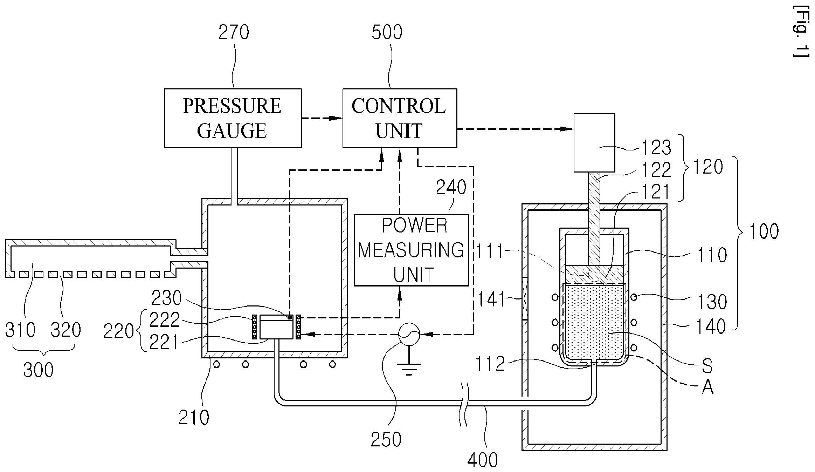

FIG. 1 is a view showing a vaporization apparatus according to one embodiment.

Referring to FIG. 1, the vaporization apparatus includes a raw material supply unit 100 that supplies a raw material S in the form of a solid or liquid, a raw material vaporization unit 200 (210, 220, 230, 240, 250, and 270) that vaporizes the raw material supplied through the raw material supply unit 100, an injector 300 that fluidly communicates with the raw material vaporization unit 200 to inject the vaporized raw material to a target space, and a control unit 500 that controls a supply quantity of the raw material supplied from the raw material supply unit 100 to the raw material vaporization unit 200 and controls a vaporization quantity of the raw material vaporized at the raw material vaporization unit 200.

The raw material supply unit 100 supplies any one of a solid raw material and a liquid raw material. For example, according to the present embodiment, a raw material S in a solid state may be liquefied in the raw material supply unit 100 so that the liquefied raw material is supplied to the raw material vaporization unit 200. For this purpose, the raw material supply unit 100 includes a liquefaction crucible 110 having a cylindrical shape to store the raw material, a liquefaction heating unit 130 liquefying the raw material by heating the liquefaction crucible 110, and a raw material discharge unit discharging the raw material from the liquefaction crucible 110, for example, a piston unit 120 inserted in one side of the liquefaction crucible 110 and adapted to discharge the raw material in a pushing manner. The raw material supply unit 100 further includes a housing 140 supplying a vacuum environment and receiving the liquefaction crucible 110 and the piston unit 120.

The liquefaction crucible 110 may have the cylindrical shape which is opened at one end and closed at the other end. The liquefaction crucible 110 supplies a predetermined storage space A therein to be filled with the raw material S. A cross section of the liquefaction crucible 110 is not limited to a circular shape but may be other polygonal shapes such as a rectangle, a pentagon, and the like. In addition, a body of the liquefaction crucible 110 includes at least one raw material inlet 111 through which the raw material S is introduced and at least one raw material outlet 112 through which the raw material S stored therein is discharged. For example, in the present embodiment, the raw material inlet 111 is disposed at an upper part of the body of the liquefaction crucible 110 whereas the raw material outlet 112 is disposed at a bottom, that is, the closed end, or a side of the body of the liquefaction crucible 110.

The liquefaction heating unit 130 is adapted to supply thermal energy generated by heating and liquefying the solid raw material S stored in the liquefaction crucible 110. The liquefaction heating unit 130 may be any structure capable of liquefying the solid raw material S and supplying thermal energy. For example, a resistor type heating element such as a core heater, a plate heater, and a lamp heater or a high-frequency heating element such as a high-frequency coil may be used for the liquefaction heating unit 130. The core heater is applied in the present embodiment, being disposed to surround an outside of the liquefaction crucible 110. However, the liquefaction heating unit 130 may not be disposed at the outer side of the liquefaction crucible 110. For example, the liquefaction heating unit 130 may be disposed in the liquefaction crucible 110 or embedded in the body of the liquefaction crucible 110. Alternatively, the housing 140 may be equipped with a heating element to function as the liquefaction heating unit 130.

The piston unit 120 is adapted to transfer the raw material S filling the storage space A of the liquefaction crucible 110 gradually to the vaporization unit 200. The piston unit 120 includes a head 121 disposed in the liquefaction crucible 110 to transfer the raw material S in a pushing manner, a rod 122, one end of which is connected to the head 121 and the other end of which extends out of the liquefaction crucible 110 to be moved integrally with the head 121, and a driver 123 connected to the other end of the rod 122 to move the rod 122. The driver 123 may include any element capable of moving the rod 122 in up and down directions, such as a motor or a hydraulic cylinder. For example, the present embodiment adopts a linear motor capable of converting a rotational motion to a linear motion and being precisely controlled.

The raw material vaporization unit 200 includes a housing 210, and a vaporizer 220 adapted to introduce the raw material into the housing 210 and vaporize the raw material.

The housing 210 supplies a predetermined space fluidly connected with the raw material outlet 112 of the liquefaction crucible 110 through a transfer pipe 400. The raw material S in a liquid state is supplied to and vaporized in the predetermined space. One end of the transfer pipe 400 is inserted in the housing 210 and extended by a predetermined length. The extending end of transfer pipe 400 is connected with the vaporizer 220 which introduces the liquid raw material to the space and vaporizes the introduced liquid raw material.

The vaporizer 220 includes a vaporization crucible 221 adapted to receive the raw material introduced into the housing 210, and a vaporization heating unit 222 adapted to heat the vaporization crucible 221 and thereby vaporize the raw material. The structures of the vaporization crucible 221 and the vaporization heating unit 222 will be described later in further detail.

The injector 300 may have a bar shape horizontally extending from one side of the housing 210 by a predetermined length. Not limited thereto, the injector 300 may extend in a vertical direction or a slanting direction according to a processing direction. The injector 300 may operate not only in a line-type injection method corresponding to its bar shape but also in a point-type injection method or a plane-type injection method. A communication path 310 is formed in a body of the injector 300, where the raw material S vaporized in the injector 300 is introduced. Additionally, a plurality of orifices 320 are formed on an outer surface of the body of the injector 300, the orifices 320 extended from the communication path 310 and opened toward the outside. Exemplarily, positions and the number of the orifices 320 are adjusted such that the vaporized raw material S is injected only in a direction toward a substrate G. In addition, although not shown, the orifices 320 may take the form of an injection nozzle protruding by a predetermined length from the body of the injector 300 to the outside. According to this, the raw material S vaporized in the raw material vaporization unit 200 flows through the communication path 310 of the injector 300 and is uniformly injected through the orifices 320 of the injector 300 in a target direction, for example, toward an upper part of the substrate.

The control unit 500 controls the overall operations of various devices mounted to the raw material liquefying unit 100, the raw material vaporization unit 200, and the injector 300 to consequently control injection quantity, injection speed and vaporization quality of a raw material gas which is finally injected through the injector 300. For this, the raw material vaporization unit 200 includes a pressure gauge 270 to detect a vaporization pressure of an inside. The control unit 500 controls driving of the piston unit 120 based on the vaporization pressure measured by the pressure gauge 270. Accordingly, quantity of the liquid raw material supplied to the raw material vaporization unit 200 is controlled. For example, an advancing speed of the head 121 of the piston unit 120 is increased to increase the supply quantity of the liquid raw material when the vaporization pressure is lower than a target value. On the other hand, the advancing speed of the head 121 is reduced to reduce the supply quantity of the liquid raw material when the vaporization pressure is higher than the target value.

In the housing 210 of the vaporization apparatus according to the embodiment, a temperature measuring unit 230 is provided to measure a surface temperature of the vaporizer 220, for example, a temperature of the vaporization crucible 221. In addition, a power measuring unit 240 is provided to measure an applied power of the vaporizer 220, for example, the vaporization heating unit 222. Therefore, a temperature variation value and a power variation value of the vaporizer 220 are transmitted to the control unit 500 in real time. Here, the 'power' may include electric power, voltage, and current. The power measuring unit 240 may measure any one of them as necessary. In general, vaporization of a raw material causes temperature change of an ambient part, for example, the vaporizer 220. Therefore, when any one of the temperature and the applied power of the vaporizer 220 is constantly maintained by the control unit 500, a minute variation of the vaporization quantity can be calculated using the temperature variation value or the power variation value of the vaporizer 220 and checked in real time. Such a process will now be described in further detail.

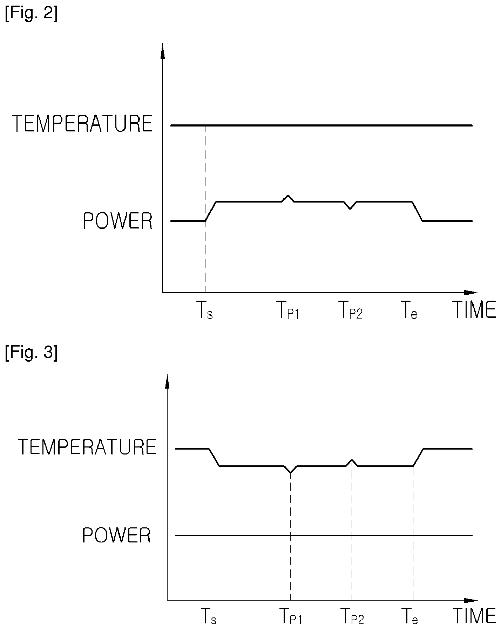

FIG. 2 is a graph showing a power variation value during a vaporization process being performed at a constant temperature according to a first experiment example. Referring to FIGS. 1 and 2, the temperature of the vaporization crucible 221 is maintained constantly from the beginning to the end of the process. Since the vaporization crucible 221 loses heat when vaporization of the raw material starts (Tₛ), the applied power of the vaporization heating unit 222 increases to maintain the constant temperature. On the other hand, when the vaporization of the raw material ends (Tₑ), the vaporization crucible 221 does not lose heat any more. Therefore, the applied power of the vaporization heating unit 222 decreases to an initial value. In addition, the applied power of the vaporization heating unit 222 is constantly maintained at a time point where the vaporization quantity is constant. However, at certain time points (Tₚ₁ and Tₚ₂) where the vaporization quantity minutely changes, the temperature of the vaporization heating unit 222 is also minutely changed. Accordingly, when the temperature of the vaporization crucible 221 is constantly maintained, the vaporization quantity can be measured very precisely through the temperature variation value of the vaporization heating unit 222.

FIG. 3 is a graph showing variation of temperature during the vaporization process being performed with a constant power according to a second experiment example. Referring to FIGS. 1 and 3, the power of the vaporization heating unit 222 is constantly maintained from the beginning to the end of the process. When vaporization of the raw material starts (Tₛ), the vaporization crucible 221 loses heat while the applied power is maintained. Therefore, the temperature of the vaporization crucible 221 decreases. On the other hand, when the vaporization ends (Tₑ), the vaporization crucible 221 does not loses heat any more. Therefore, the temperature of the vaporization crucible 221 increases to an initial temperature. When the vaporization quantity is constant, the temperature of the vaporization crucible 221 is also constantly maintained. However, when the vaporization quantity minutely changes at certain time points (Tₚ₁ and Tₚ₂), the temperature of the vaporization crucible 221 is also minutely changed. Therefore, when the applied power of the vaporization heating unit 222 is constantly maintained, the vaporization quantity may be measured very precisely through the power variation value of the vaporization crucible 221.

As described above, the vaporization apparatus supplies the raw material S to the vaporization crucible 221 and then vaporizes the raw material S in the vaporization heating unit 222. Here, the control unit 500 controls the supply quantity and the vaporization speed of the raw material based on the vaporization quantity measured by the pressure gauge 270. Furthermore, the vaporization quantity is more precisely checked based on the temperature variation value of the vaporization crucible 221 measured by the temperature measuring unit 230 or the power variation value of the vaporization heating unit 222 measured by the power measuring unit 240, so that the control unit 500 controls the supply quantity and the vaporization speed of the raw material more minutely. That is, the injection quantity and speed of the raw material injected through the injector 300 and the vaporization quality may be more minutely controlled as desired by using both a first vaporization quantity measuring unit which includes the pressure gauge 270 and a second vaporization quantity measuring unit which includes the temperature measuring unit 230 and the power measuring unit 240. Here, the first and the second vaporization quantity measuring units may be designated as a main unit and an auxiliary unit and used complementarily.

In addition, the vaporization apparatus is capable of not only checking the vaporization quantity in real time but also obtaining various information on the vaporization process, including the vaporization speed, the vaporization temperature, and the vaporization power. Accordingly, it is convenient to set the optimum vaporization conditions according to characteristics of the raw material.

Also, a solid raw material and a liquid raw material are both applicable to the vaporization apparatus according to the embodiment. Since the gradual vaporization method which liquefies a large quantity of the raw material in the raw material liquefaction unit 100 and vaporizes only a small quantity of them in the raw material vaporization unit 200 is adopted, productivity may be increased according to the large quantity of the raw material. Furthermore, since the small quantity is vaporized, it is convenient to control the deposition speed and maintain the deposition and quality. Since only the small part of the large quantity raw material is vaporized, energy consumption may be minimized.

The vaporizer of the vaporization apparatus according to the embodiment may be modified in various manners to improve the vaporization speed and quality. Hereinafter, various vaporizers according to the embodiments will be suggested and described.

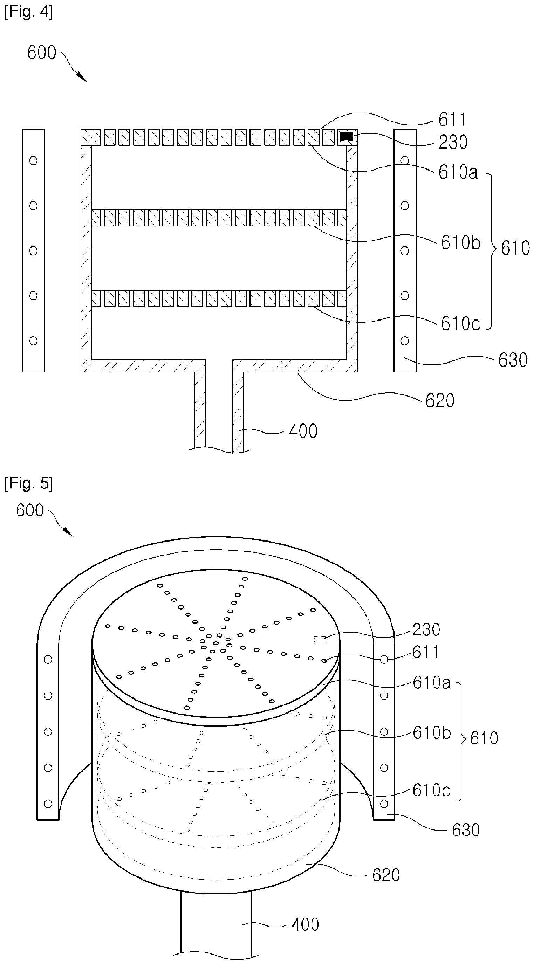

FIG. 4 is a sectional view of a vaporization apparatus according to a first modified version of the embodiment. FIG. 5 is a perspective view of the vaporization apparatus according to the first modified version of the embodiment.

Referring to FIGS. 4 and 5, a vaporizer 600 includes a vaporization crucible constituted by a body part 620 which is connected to the transfer pipe 400 and includes an inner space to receive the raw material supplied through the transfer pipe 400, and discharge plates 610 (610a, 610b, and 610c) connected to the body part 620. The discharge plates 610 each include at least one outlet 611 formed on a surface thereof to discharge the raw material received in the inner space. The vaporizer 600 further comprises a vaporization heating unit 630 disposed at the outside of the vaporization crucible. The vaporization heating unit 630 may surround the whole or a part of an outer circumference of the vaporization crucible.

The body part 620 has a cylindrical shape with one end opened and the other end closed. The discharge plate 610 is connected to the open area, thereby forming inner spaces inside the cylinder defined by the discharge plate 610. Additionally, the transfer pipe 400 may be connected to penetrate a lower wall or a sidewall of the body part 620 and fluidly communicate with the inner spaces of the body part 620.

The discharge plate 610 has a plane plate shape with at least one outlet 611 formed on the surface thereof. Exemplarily, a plurality of outlets 611 are provided and arranged radially and symmetrically for uniform discharge of the raw material. Also, the discharge plate 610 may include the plurality of discharge plates 610a to 610c partitioning the inner space of the body part 620 into upper and lower spaces.

In the above structured vaporizer 600, some of the plurality of discharge plates 610a to 610c separately arranged in the up and down direction in the inner space of the body part 620 uniformize a discharge flow. Therefore, uniformity of the raw material discharge may be increased.

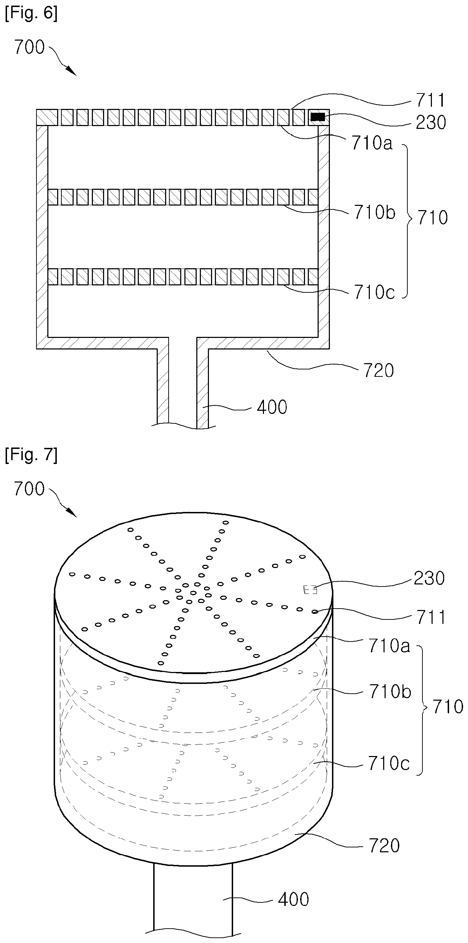

FIG. 6 is a sectional view of a vaporization apparatus according to a second modified version of the embodiment. FIG. 7 is a perspective view of the vaporization quantity according to the second modified version of the embodiment.

Referring to FIGS. 6 and 7, a vaporizer 700 is constituted by a discharge plate 710 (710a, 710b, and 710c) having a plate form and a vaporization heating unit (not shown) embedded in the discharge plate 710. The discharge plate 710 including the embedded vaporization heating unit (not shown) is provided in a plural number, that is, the discharge plates 710a, 710b, and 710c to partition an inner space of a body part 720 into upper and lower spaces. It is exemplary that the body part 720 is made of an insulating material such as ceramic.

The vaporization crucible and the vaporization heating unit (not shown) of the vaporizer 700 are integrally formed with each other, thereby achieving a simple appearance thereof while minimizing damage of the vaporization heating unit (not shown) which is exposed. In addition, since the discharge plates 710a, 710b, and 710c heat the raw material gradually, the vaporization speed and quality are enhanced.

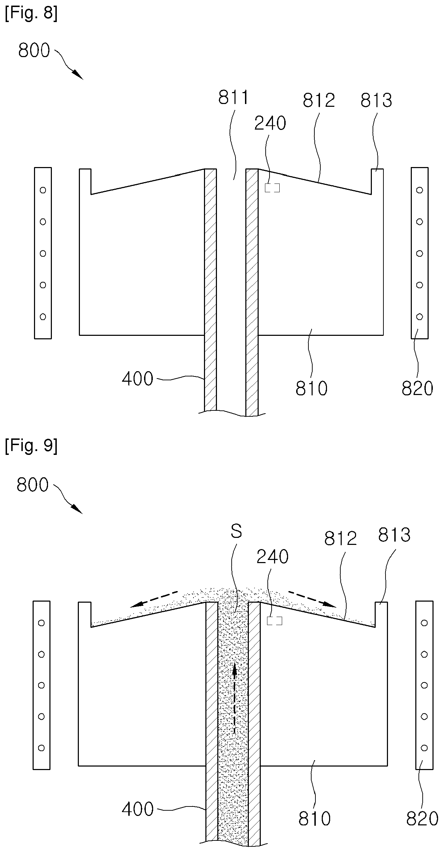

FIG. 8 is a sectional view showing a vaporization apparatus according to a third modified version of the embodiment. FIG. 9 is a sectional view showing operational processes of the vaporization apparatus according to the third modified version.

Referring to FIGS. 8 and 9, a vaporizer 800 includes a vaporization crucible and a vaporization heating unit 820. The vaporization crucible adapted to receive the raw material S is constituted by a body part 810 supplying a bottom surface 812 and a sidewall ring 813 extending upward from a circumference of the bottom surface 812. The vaporization heating unit 820 is disposed at the outside of the vaporization crucible. The transfer pipe 400 that supplies the raw material is connected to a center of the bottom surface 812 of the vaporization crucible 810 in a penetrating manner. In addition, the bottom surface 812 is configured such that a center is higher than a periphery, thereby forming a slope in the form of a lampshade convex upward. According to this structure, the liquid raw material S supplied through the transfer pipe 400 flows along the slope and disperses in every direction. Therefore, since a raw material heating area is increased, the vaporization speed is increased.

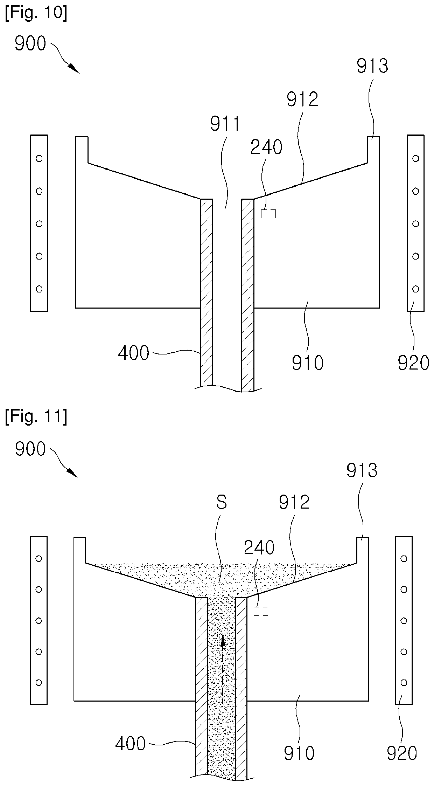

FIG. 10 is a sectional view of a vaporizer according to a fourth modified version of the embodiment. FIG. 11 is a sectional view showing operational processes of the vaporization apparatus according to the fourth modified version.

Referring to FIGS. 10 and 11, a vaporizer 900 includes a vaporization crucible adapted to receive the raw material S. The vaporization crucible is constituted by a body part 910 supplying a bottom surface 912, and a sidewall ring 913 extending upward from a circumference of the bottom surface 912. A vaporization heating unit 920 is disposed at the outside of the vaporization crucible. Differently from the previous version, the bottom surface 912 is configured to have a center lower than a periphery, thereby forming a slope in the form of a funnel concave downward. According to this structure, the liquid raw material S supplied through the transfer pipe 400 fills from a lower part, that is, the center of the bottom surface 912 of the vaporization crucible 910, forming a horizontally even height. Since the raw material is vaporized from the even height, the vaporization speed may be stabilized.

Thus, through various modified structures of the vaporizer, the optimum conditions for fast and stable vaporization may be secured according to characteristics of the raw material.

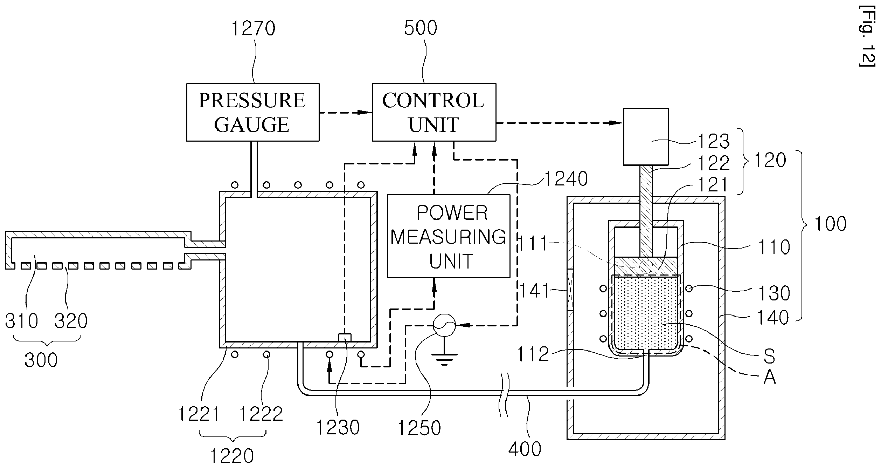

FIG. 12 is a view showing a vaporization apparatus according to a second embodiment.

Referring to FIG. 12, the vaporization apparatus of the present embodiment includes the raw material supply unit 100 that supplies the raw material S, a raw material vaporization unit 1200 (1220, 1230, 1240, and 1250) that vaporizes the raw material S supplied from the raw material supply unit 100, the injector 300 that fluidly communicates with the raw material vaporization unit 1200 and injects the vaporized raw material to a target space, and the control unit 500 that controls a supply quantity of the raw material supplied from the raw material supply unit 100 to the raw material vaporization unit 1200 and a vaporization quantity of the raw material vaporized at the raw material vaporization unit 1200.

The raw material vaporization unit 1200 includes a vaporization crucible 1221 supplying a vaporization space and receiving the raw material introduced into the vaporization space, and a vaporization heating unit 1222 vaporizing the raw material by heating the vaporization crucible 1221.

The vaporization apparatus further includes a temperature measuring unit 1230 measuring an inner temperature of the vaporization crucible 1221, for example, a bottom temperature, and a power measuring unit 1240 measuring power of the vaporization heating unit 1222. Also, the vaporization apparatus includes a pressure gauge 1270 detecting the vaporization pressure inside the vaporization crucible 1221. Therefore, the control unit is able to calculate the vaporization quantity of the raw material very precisely by receiving information on the temperature variation value of the vaporization crucible 1221, the power variation value of the vaporization heating unit 1222, and the pressure variation of the vaporization crucible 1221 in real time.

The above-structured vaporization apparatus according to the second embodiment may reduce the cost since the vaporization crucible 1221 functions as the housing 210 (FIG. 1).

The vaporization apparatuses according to the first and the second embodiments are applicable to various film deposition devices which form a predetermined film on a substrate by vaporizing a solid or liquid raw material and supplying the vaporized raw material into the chamber, such as a plasma enhanced chemical vapor deposition (PECVD) device and a metal organic CVD (MOCVD) device.

Although the vaporization apparatus and a control method for the same have been described with reference to the specific embodiments, it is not limited thereto. Therefore, it will be readily understood by those skilled in the art that various modifications and changes can be made thereto without departing from the present invention defined by the appended claims.

## Claims

1. A vaporization apparatus comprising:
a liquefaction crucible (110) adapted to store a solid raw material (S);
a liquefaction heating unit (130) adapted to liquefy the solid raw material by heating the liquefaction crucible (110);
a piston unit (120) inserted in one side of the liquefaction crucible (110) and adapted to discharge the raw material in a pushing matter;
a vaporization crucible (221) connected to the liquefaction crucible (110) and adapted to vaporize the raw material supplied from the liquefaction crucible (110);
a housing (210) disposed to surround the vaporization crucible (221);
a vaporization heating unit (222) adapted to vaporize the raw material by heating the vaporization crucible;
a temperature measuring unit (230) adapted to measure temperature of the vaporization crucible (221);
a power measuring unit (240) adapted to measure an applied power of the vaporization heating unit (222); and
a pressure gauge (270) adapted to measure a vaporization pressure in the housing (210), and
**characterized by**
a control unit (500) adapted to control a driving rate of the piston unit (120) based on the vaporization pressure measured by the pressure gauge (270) and to control a vaporization quantity of the raw material based on a vaporization pressure of the pressure gauge (270), and to control a vaporization quantity based on a temperature variation value of the temperature measuring unit (230) or a power variation value of the power measuring unit (240).

## Patentansprüche

1. Verdampfungsvorrichtung, umfassend:
einen Verflüssigungstiegel (110), der angepasst ist, um ein festes Rohmaterial (S) zu lagern;
eine Verflüssigungsheizeinheit (130), die angepasst ist, um das feste Rohmaterial durch Erhitzen des Verflüssigungstiegels (110) zu verflüssigen;
eine Kolbeneinheit (120), die in eine Seite des Verflüssigungstiegels (110) eingeführt und angepasst ist, um das Rohmaterial auf drückende Weise abzugeben;
einen Verdampfungstiegel (221), der mit dem Verflüssigungstiegel (110) verbunden und angepasst ist, um das aus dem Verflüssigungstiegel (110) zugeführte Rohmaterial zu verdampfen;
ein Gehäuse (210), das angeordnet ist, um den Verdampfungstiegel (221) zu umgeben;
eine Verdampfungsheizeinheit (222), die angepasst ist, um das Rohmaterial durch Erhitzen des Verdampfungstiegels zu verdampfen;
eine Temperaturmesseinheit (230), die angepasst ist, um die Temperatur des Verdampfungstiegels (221) zu messen;
eine Leistungsmesseinheit (240), die angepasst ist, um eine angelegte Leistung der Verdampfungsheizeinheit (222) zu messen; und
ein Manometer (270), das angepasst ist, um einen Verdampfungsdruck in dem Gehäuse (210) zu messen,
und
**gekennzeichnet durch**
eine Steuereinheit (500), die angepasst ist, um eine Antriebsgeschwindigkeit der Kolbeneinheit (120) auf der Basis des Verdampfungsdrucks, der von dem Manometer (270) gemessen wird, zu steuern und um eine Verdampfungsmenge des Rohmaterials auf der Basis eines Verdampfungsdrucks des Manometers (270) zu steuern und um eine Verdampfungsmenge auf der Basis eines Temperaturvariationswerts der Temperaturmesseinheit (230) oder einen Leistungsvariationswert der Leistungsmesseinheit (240) zu steuern.

## Revendications

1. Appareil de vaporisation, comprenant:
un creuset de liquéfaction (110) adapté pour stocker une matière première solide (S);
une unité de chauffage de liquéfaction (130) adaptée pour liquéfier la matière première solide en chauffant le creuset de liquéfaction (110);
une unité de piston (120) insérée dans un premier côté du creuset de liquéfaction (110) et adaptée pour décharger la matière première par poussée;
un creuset de vaporisation (221) connecté au creuset de liquéfaction (110) et adapté pour vaporiser la matière première fournie par le creuset de liquéfaction (110);
un boîtier (210) disposé de manière à entourer le creuset de vaporisation (221);
une unité de chauffage de vaporisation (222) adaptée pour vaporiser la matière première en chauffant le creuset de vaporisation;
une unité de mesure de la température (230) adaptée pour mesurer la température du creuset de vaporisation (221);
une unité de mesure de la puissance (240) adaptée pour mesurer une puissance appliquée de l'unité de chauffage de vaporisation (222); et
une jauge de pression (270) adaptée pour mesurer une pression de vaporisation dans le boîtier (210), et
**caractérisé par**:
une unité de commande (500) adaptée pour commander une vitesse d'entraînement de l'unité de piston (120) sur la base de la pression de vaporisation mesurée par la jauge de pression (270) et pour commander une quantité de vaporisation de la matière première sur la base d'une pression de vaporisation de la jauge de pression (270), et pour commander une quantité de vaporisation sur la base d'une valeur de variation de température de l'unité de mesure de la température (230) ou d'une valeur de variation de puissance de l'unité de mesure de la puissance (240).
